Europäisches Patentamt

European Patent Office

Office européen des brevets

(19)

(11) Numéro de publication : **0 143 676**
**B1**

(12) **FASCICULE DE BREVET EUROPÉEN**

(45) Date de publication du fascicule du brevet :
**20.01.88**

(21) Numéro de dépôt : **84401753.3**

(22) Date de dépôt : **03.09.84**

(51) Int. Cl.⁴ : **C 30 B 15/30**, H 02 K 26/00

(54) **Tête de tirage de monocristaux.**

(30) Priorité : **06.09.83 FR 8314219**

(43) Date de publication de la demande :
**05.06.85 Bulletin 85/23**

(45) Mention de la délivrance du brevet :
**20.01.88 Bulletin 88/03**

(84) Etats contractants désignés :
**DE GB NL**

(56) Documents cités :
**US-A- 2 975 036**
**JOURNAL OF CRYSTAL GROWTH, vol. 41, no. 2, décembre 1977, pages 262-274, North-Holland Publishing Company, Amsterdam, NL; D. MATEIKA et al.: "Automatisierte Kristallziehanlage für das Czochralksi-Verfahren"**

(73) Titulaire : **COMMISSARIAT A L'ENERGIE ATOMIQUE**
**31/33, rue de la Fédération**
**F-75015 Paris (FR)**

(72) Inventeur : **Lissalde, François**
**6, rue des Bleuets**
**F-38170 Seyssinet (FR)**
Inventeur : **Bathelet, Pierre**
**Cidex 258 Les Eglantines**
**F-38190 Brignoud (FR)**
Inventeur : **Ferrieu, Bruno**
**247 Résidence Percevalière**
**F-38170 Seyssinet (FR)**
Inventeur : **Brochier, Michel**
**Hauts Villeneuve**
**F-38560 Haute Jarrie (FR)**

(74) Mandataire : **Mongrédien, André et al**
**c/o BREVATOME 25, rue de Ponthieu**
**F-75008 Paris (FR)**

EP 0 143 676 B1

## Description

La présente invention se rapporte à une machine de tirage de monocristaux à partir d'un bain de produit fondu. Ce bain contenu dans un creuset est maintenu à une température supérieure au point de fusion du produit par des moyens de chauffage appropriés. On peut alors obtenir un cristal massif à l'aide d'un germe monocristallin du même produit placé à l'extrémité inférieure d'une broche de tirage d'axe vertical, selon la méthode dite de Czochralski.

Les machines de tirage de ce type sont principalement utilisées pour la cristallisation de matériaux pour lesquels il est possible de trouver des conditions où le solide cristallisé a la même composition que le liquide (corps à fusion congruente), tels que certains oxydes et les semiconducteurs du type silicium et germanium.

Dans ces machines, le germe monocristallin est amené au contact du bain liquide, dont la température est ajustée de façon qu'à l'interface solide-liquide existent des conditions telles qu'à chaque instant la quantité d'atomes cristallisés soit identique à la quantité d'atomes qui retournent en fusion. La croissance est obtenue en exerçant sur la broche de tirage un mouvement régulier de translation verticale, à une vitesse généralement comprise entre 1 et 30 mm par heure. Pour contrôler la forme de l'interface, on superpose au mouvement de translation un mouvement de rotation de la broche autour de son axe, à une vitesse généralement comprise entre 0 et 100 tours par minute. Le déplacement vers le haut de l'interface solide-liquide amène celle-ci dans une zone plus froide, ce qui a pour effet de faire cristalliser le bain sur le germe et ainsi de faire croître le monocristal.

En raison de la lenteur du mouvement de translation verticale appliqué à la broche de tirage pendant une croissance cristalline, il est d'usage de munir les machines de tirage de monocristaux de moyens de translation rapide de la broche, afin de réaliser la descente du germe jusqu'à proximité du bain fondu.

Dans l'état actuel de la technique, et comme l'illustre notamment le document US-A-2 975 036, les déplacements en translation lent et rapide de la broche sont commandés par deux moteurs électriques classiques qui agissent sur un système à circulation de billes par l'intermédiaire d'un embrayage et de réducteurs. De même, la broche est entraînée en rotation par un ensemble motoréducteur. L'utilisation de moteurs et de réducteurs est évidemment très coûteuse. De plus, la présence de ces réducteurs conduit à introduire des jeux et des vibrations qui sont tout à fait préjudiciables à la régularité de mouvement requise lors du tirage du monocristal. En outre, l'utilisation d'un système à circulation de billes crée des à-coups lors du déplacement lent de la broche de tirage. La qualité des monocristaux obtenus s'en trouve amoindrie, notamment en raison de la présence de dislocations dans ces monocristaux.

La nécessité d'obtenir des monocristaux de géométrie régulière a conduit les fabricants de machines à mettre au point des régulations de diamètre. Dans les machines actuelles où cette régulation se fait par l'intermédiaire d'une mesure de poids, un capteur placé judicieusement enregistre continuement soit la prise de poids du cristal, soit la perte de masse du bain fondu.

La méthode de pesée du creuset est simple mais implique pour des raisons expérimentales la pesée inutile des réfractaires nécessaires à l'isolation thermique du montage. De plus la mesure est entachée des erreurs liées aux forces de lévitation qui s'exercent sur le creuset dans le cas d'un chauffage haute fréquence.

La technique utilisée dans la présente invention est la pesée du cristal en cours de croissance. Cette méthode n'a pas les inconvénients cités précédemment mais implique pour cela l'insertion d'un capteur de poids dans la broche. Ce transducteur est donc nécessairement entraîné en rotation par cette dernière.

Selon la technique actuelle, pour ressortir les informations vers les parties fixes, retourner des ordres vers la partie rotative et alimenter en courant électrique le capteur en rotation, il est fait appel à des contacts tournants peu fiables et d'une durée de vie limitée.

La présente invention a précisément pour objet une machine de tirage de monocristaux selon la méthode de Czochralski, ne présentant pas les défauts des machines connues et permettant notamment des mouvements de rotation et de déplacement vertical lent de la broche de tirage sensiblement plus régulier, tout en étant d'un coût avantageux et d'une conception relativement simple.

De plus, la présente invention vise à améliorer considérablement la fiabilité des machines de tirage en éliminant tout contact tournant entre les parties rotatives de la machine et les parties fixes, ceci à l'exception des balais des moteurs et des dynamos tachymétriques.

A cet effet et conformément à l'invention, il est proposé une machine de tirage de monocristaux comprenant un bâti fixe, un chariot supporté par le bâti et mobile par rapport audit bâti selon une direction parallèle à l'axe de la broche de tirage, et des moyens pour guider le chariot par rapport au bâti ; des premiers moyens de commande montés sur le bâti pour déplacer ledit chariot dans ladite direction selon au moins deux vitesses différentes en agissant sur une vis reçue dans un écrou monté sur le chariot, le chariot supportant la broche de tirage de façon tournante autour de l'axe de cette dernière, et des seconds moyens de commande montés sur le chariot pour faire tourner la broche de tirage autour de son axe vertical, cette machine étant caractérisée en ce que :

— les premiers moyens de commande comprennent un seul moteur couple asservi en position et en vitesse, ce moteur étant en prise directe sur la vis ;

— les seconds moyens de commande comprennent un second moteur couple asservi en vitesse, ce moteur étant en prise directe sur la broche de tirage ;

— la broche de tirage est formée de deux parties séparées reliées fixement par un capteur de poids tournant avec les deux parties de la broche et délivrant des signaux électriques transmis à un premier circuit de traitement électronique solidaire de la broche de tirage ;

— le premier circuit de traitement électronique délivre des signaux électriques qui sont transmis à un deuxième circuit de traitement électronique, indépendant de la broche de tirage, par un système électro-optique disposé selon l'axe de la broche entre le premier circuit de traitement électronique et le chariot ;

— la machine comprenant de plus une source d'alimentation électrique du premier circuit de traitement électronique indépendante de la broche de tirage, et un transformateur disposé entre le chariot et la broche de tirage et par lequel ladite source est reliée électriquement et sans contact au premier circuit de traitement électronique ;

— des moyens pour délivrer des ordres de commande au premier circuit de traitement électronique, ces moyens étant indépendants de la broche de tirage, et des moyens de couplage capacitifs disposés entre le chariot et la broche de tirage et par lesquels les moyens pour délivrer des ordres de commande sont reliés électriquement et sans contact au premier circuit de traitement électronique.

De préférence, afin d'améliorer la stabilité du système vis-à-vis des fluctuations thermiques environnantes, le capteur de poids est logé dans une enceinte thermiquement isolante solidaire dudit chariot.

Dans le même but, la machine de tirage comprend de plus une sonde de température et un moyen de chauffage placés dans ladite enceinte, un circuit de régulation externe sensible aux signaux délivrés par la sonde de température commandant la mise en œuvre du moyen de chauffage afin de maintenir la température sur le capteur de poids à une valeur constante.

En complément, chacune des parties de la broche comporte au moins une zone en matériau isolant au voisinage du capteur de poids.

De préférence, le capteur de poids comprend une pièce interne et une pièce externe solidaires respectivement de chacune des deux parties de la broche de tirage et centrées selon l'axe de cette dernière respectivement par une partie en saillie de la pièce interne logée dans un trou borgne de la partie correspondante de la broche et par un embrèvement.

Selon un autre aspect de la machine de tirage selon l'invention, le chariot comprend une première partie portant lesdits moyens de guidage et ladite vis, une deuxième partie portant la broche de tirage et les moyens pour en commander la rotation, l'ensemble constitué par la deuxième partie du chariot et par la broche de tirage présentant pour l'essentiel une symétrie de révolution autour de l'axe de ladite broche, et des moyens de liaison rigides et réglables entre ces deux parties du chariot, permettant de conférer à l'axe de la broche l'orientation verticale souhaitée.

Les moyens de guidage du chariot par rapport au bâti peuvent être constitués par un rail de guidage solidaire du bâti et sur lequel roulent des galets portés par le chariot, ainsi que par tout moyen équivalent tel qu'un système à coussin d'air.

On décrira maintenant, à titre d'exemple non limitatif, un mode de réalisation particulier de l'invention en se référant aux dessins annexés dans lesquels :

— la figure 1 est une vue de face représentant de façon schématique une machine de tirage de monocristaux réalisée conformément à la présente invention,

— la figure 2 est une vue de côté, en coupe partielle et à plus grande échelle, représentant plus en détail la partie supérieure de la broche de tirage et le chariot qui la supporte, et

— la figure 3 est une vue comparable à la figure 2 illustrant plus particulièrement la transmission des signaux entre la broche de tirage et la console de commande de la machine.

En premier lieu, on remarquera que la machine de tirage selon l'invention se distingue essentiellement des machines selon la technique antérieure au niveau de la tête de tirage, c'est-à-dire au niveau des moyens permettant de commander la translation verticale de la broche de tirage le long de son axe et des moyens pour commander la rotation de la broche autour de cet axe. Il découle de cette remarque préliminaire que toutes les parties de la machine non décrites et non représentées seront réalisées selon les connaissances ordinaires de l'homme du métier par tout moyen approprié connu ou à découvrir.

En particulier, lorsque le bain fondu se transforme en monocristal au fur et à mesure de la montée de la broche de tirage, il se produit une baisse du niveau de ce bain dans le creuset qui nécessite, pour garder constante la vitesse de croissance du cristal et conserver fixe dans le gradient thermique la position de l'interface solide-liquide, de déplacer d'un mouvement lent le creuset vers le haut et corrélativement de moduler la vitesse de tirage. Les moyens pour commander le déplacement du creuset ne font pas partie de la présente invention et peuvent être réalisés par tous moyens connus appropriés. Ils ne seront pas décrits dans cette demande.

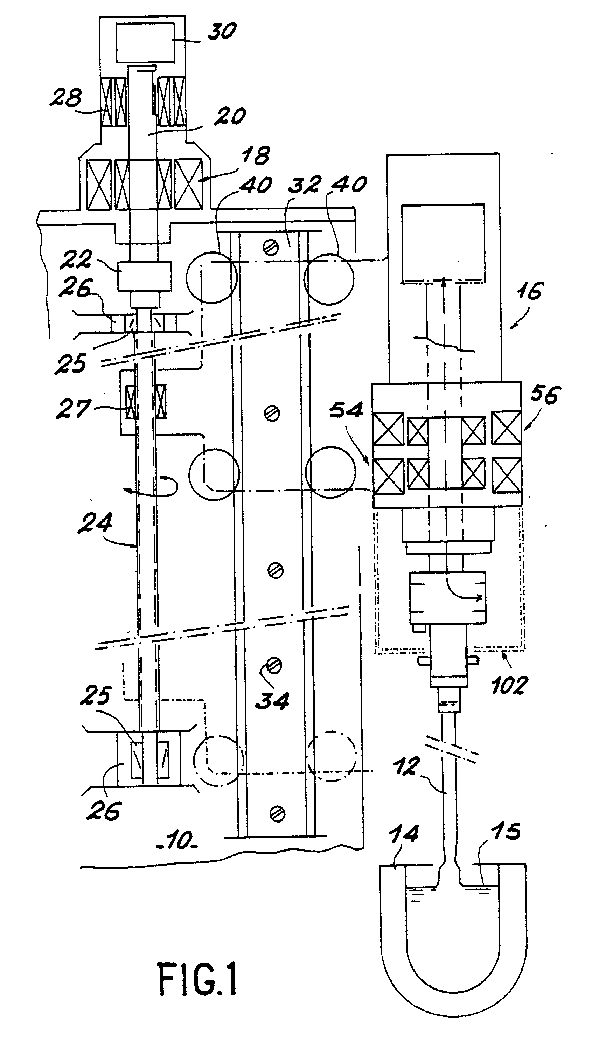

Sur la figure 1, on a représenté une partie du bâti 10 de la machine, supportant la broche de tirage 12, d'axe vertical, au-dessus du creuset 14 rempli d'un bain 15 de produit fondu à cristalliser, par l'intermédiaire d'un chariot 16 mobile verticalement par rapport au bâti 10.

La commande du déplacement vertical du chariot 16 par rapport au bâti 10 est réalisée par un moteur couple 18 monté à la partie supérieure du bâti, de façon à entraîner directement en rotation un arbre 20, d'axe vertical, dont l'extrémité inférieure est solidarisée par un accouplement 22 d'une tige filetée d'axe vertical 24 montée de façon tournante dans des tourillons 26 solidaires du bâti 10, par l'intermédiaire de roulements 25. Comme tous les autres roulements de la machine, les roulements 25 sont des roulements sans jeu à contact oblique ou à gorge profonde.

Un écrou 27, solidaire du chariot 16 est reçu sur la tige filetée 24, de telle sorte que l'entraînement de celle-ci en rotation par le moteur couple 18 a pour effet de déplacer le chariot 16 selon un mouvement de translation verticale.

L'utilisation d'un moteur couple 18 permet des mouvements particulièrement doux et supprime les réducteurs et les embrayages utilisés selon la technique antérieure. De plus, un seul moteur couple permet de commander à la fois les déplacements lents (vitesse de translation comprise à volonté entre 1 et 30 mm par heure pour le tirage) et les déplacements rapides (vitesse de translation de 95 mm par minute pour l'approche) de la broche de tirage.

Afin d'assurer la régularité de ces déplacements, notamment lors du tirage du monocristal, le moteur couple 18 est asservi en vitesse et en position. A cet effet, on associe au moteur 18 un capteur de vitesse tel qu'un dynamo tachymétrique 28 et un codeur de position tel qu'un synchro-résolveur 30. Pour simplifier, on n'a pas représenté sur la figure 1 les boucles d'asservissement par lesquelles les signaux délivrés par la dynamo tachymétrique et par le synchro-résolveur permettent d'asservir en vitesse et en position le moteur couple 18. De telles boucles d'asservissement sont en effet bien connues et ne font pas partie de la présente invention.

De même, la commande du moteur couple 18 à partir de l'armoire de commande, afin de régler la vitesse et le sens de déplacement de la broche de tirage 12, peut être réalisée par tout moyen approprié et ne sera pas décrite ici en détail.

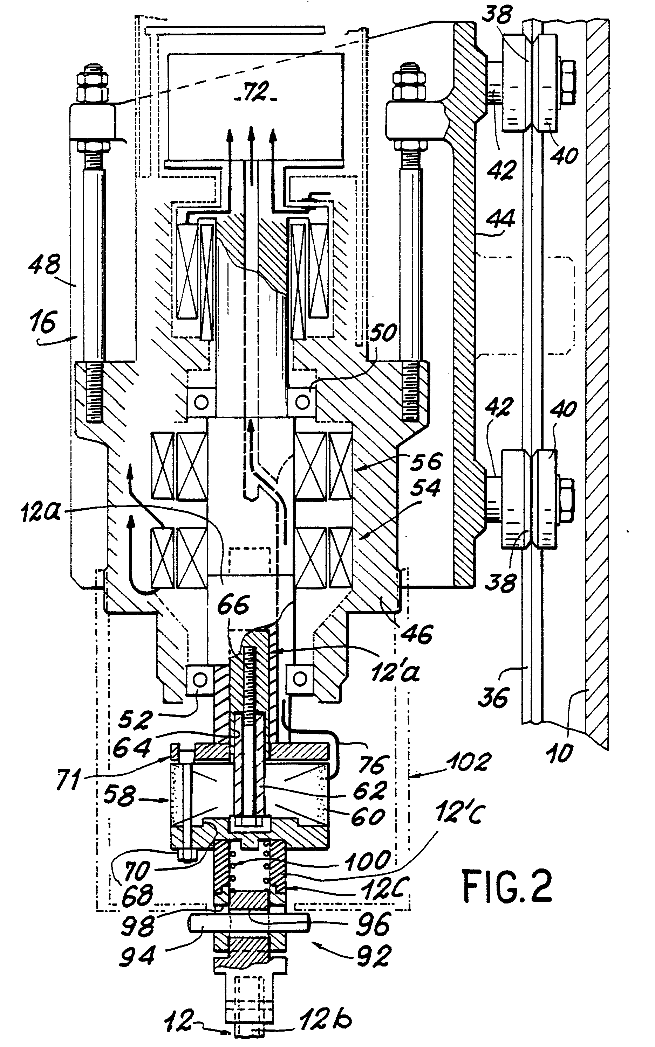

Conformément à une autre caractéristique de l'invention, le déplacement en translation verticale du chariot 16 portant la broche de tirage 12, par rapport au bâti 10, est guidé par des moyens appropriés distincts de l'ensemble vis-écrou 24, 27. Dans le mode de réalisation représenté sur les figures 1 et 2, ces moyens de guidage sont constitués par un rail ou une glissière verticale rectifiée 32 fixé sur le bâti 10, par exemple au moyen de vis 34, et dont les bords verticaux 36 présentent une section en forme de V. Ces bords 36 du rail 32 pénètrent dans des gorges 38 de même section formées dans au moins deux paires de galets rectifiés 40 décalées verticalement l'une par rapport à l'autre. Les axes 42 des galets 40 sont solidaires du chariot 16.

Bien entendu, ces moyens de guidage pourraient être constitués par tout autre moyen équivalent et notamment par un système de guidage à coussin d'air permettant de réduire les frottements et donc d'améliorer encore la régularité du déplacement du chariot 16 par rapport au bâti.

Quel que soit le moyen de guidage utilisé, il est à noter que le déplacement du chariot par rapport au bâti se fait sans à-coup ni vibrations, ce qui constitue un avantage important par rapport à la technique antérieure.

Comme le montre en particulier la figure 2, le chariot 16 comprend une première partie 44 portant l'écrou 27 et les axes 42 supportant les galets de guidage 40 et une deuxième partie 46 présentant de façon générale une symétrie de révolution autour de l'axe vertical de la broche de tirage 12. La partie 46 du chariot est suspendue à la partie 44 par des tirants rigides 48, de longueur réglable, circonférentiellement répartis autour de la broche, de façon à permettre un réglage très précis de l'orientation verticale de l'axe de la broche.

On voit également sur la figure 2 que la partie supérieure de la broche de tirage 12 pénètre dans la partie 46 du chariot, dans laquelle elle est suspendue de façon tournante par l'intermédiaire d'une butée 52 et d'un roulement 50, également sans jeu. L'entraînement en rotation de la broche 12 à l'intérieur de la partie 46 du chariot est réalisé à l'aide d'un deuxième moteur couple 54, asservi en vitesse au moyen d'un capteur de vitesse tel qu'une dynamo tachymétrique 56 et d'un circuit d'asservissement connu (non représenté). Il est à noter que le moteur couple 54 est en prise directe sur la broche 12. De la même manière que pour le moteur 18, la commande du moteur 54 peut être réalisée par tout moyen approprié et ne sera pas décrite ici en détail.

Comme pour le moteur de commande de translation 18, le moteur couple 54 permet un mouvement particulièrement doux et supprime tout réducteur mécanique. Le moteur couple 54 permet d'imprimer à la broche de tirage un mouvement de rotation réglable entre 0 et 100 tours par minute.

La stabilité de vitesse obtenue grâce à l'utilisation des moteurs couples 18 et 54 est meilleure que 2,5 pour cent, ce qui constitue un résultat très supérieur aux résultats obtenus à l'aide des machines de tirages connues, sachant que l'ensemble décrit ici ne comporte aucun démultiplicateur.

Conformément à un aspect intéressant de l'invention permettant notamment de réaliser la trempe automatique du germe dans le bain contenu dans le creuset, on interpose un capteur de poids 58 directement dans la broche de tirage 12.

Lors de la croissance du cristal, la pesée réalisée à l'aide du capteur 58 représente, au poids de la partie inférieure de la broche de tirage près, la pesée du monocristal, et elle permet donc d'intervenir sur la puissance de chauffage du creuset afin de réguler le diamètre du cristal obtenu. Cette technique connue est améliorée conformément à l'invention à la fois en donnant au capteur 58 une structure particulière permettant d'éviter tout décalage gênant entre les axes des deux parties de la broche reliées par le capteur et en proposant une solution originale au problème posé par la transmission des informations délivrées par le capteur solidaire de la broche tournante vers des parties non tournantes de la machine.

De façon connue, le capteur de poids 58 se compose d'une pièce externe 60 et d'une pièce interne 62 entre lesquelles sont disposés des capteurs de déformation (non représentés) tels que des jauges de contrainte.

Afin d'améliorer l'alignement des axes de la partie supérieure 12a et de la partie inférieure 12b de la broche de tirage 12 par rapport à la technique connue, on voit sur la figure 2 que la pièce centrale 62 se prolonge vers le haut en saillie au-dessus de la face supérieure de la pièce externe 60, pour pénétrer dans un trou borgne 64 formé dans la partie 12a de la broche, à laquelle elle est fixée par une vis 66. De façon comparable, la pièce externe 60, qui est fixée à la partie inférieure 12b de la broche de tirage par des vis 68, est centrée par rapport à cette partie 12b au moyen d'un embrèvement 70. Ainsi, l'alignement des axes des deux parties de la broche de tirage peut être obtenu avec une bonne précision.

On voit aussi sur la figure 2 qu'un disque 71, de même diamètre que la pièce externe 60, est fixé au-dessus de celle-ci à l'extrémité inférieure de la partie 12a de la broche, par exemple au moyen de vis (non représentées). Ce disque 71, qui définit avec la pièce 60 un intervalle relativement petit, constitue une butée servant à contrebalancer les efforts radiaux ou de compression qui pourraient être accidentellement appliqués au capteur. Pour une bonne efficacité de cette butée, l'intervalle entre le disque 71 et la pièce 60 est, de préférence, limité à 1/10 de mm environ.

Afin d'améliorer la stabilité du système vis-à-vis des fluctuations thermiques environnantes, on voit sur la figure 2 que le capteur de poids 58, ainsi que toute la zone de la broche de guidage située entre l'extrémité inférieure de la partie 46 du chariot et le dispositif démontable 92 qui sera décrit ultérieurement, sont logés dans une enceinte 102. Cette enceinte 102 est réalisée en aluminium poli sur ses faces interne et externe.

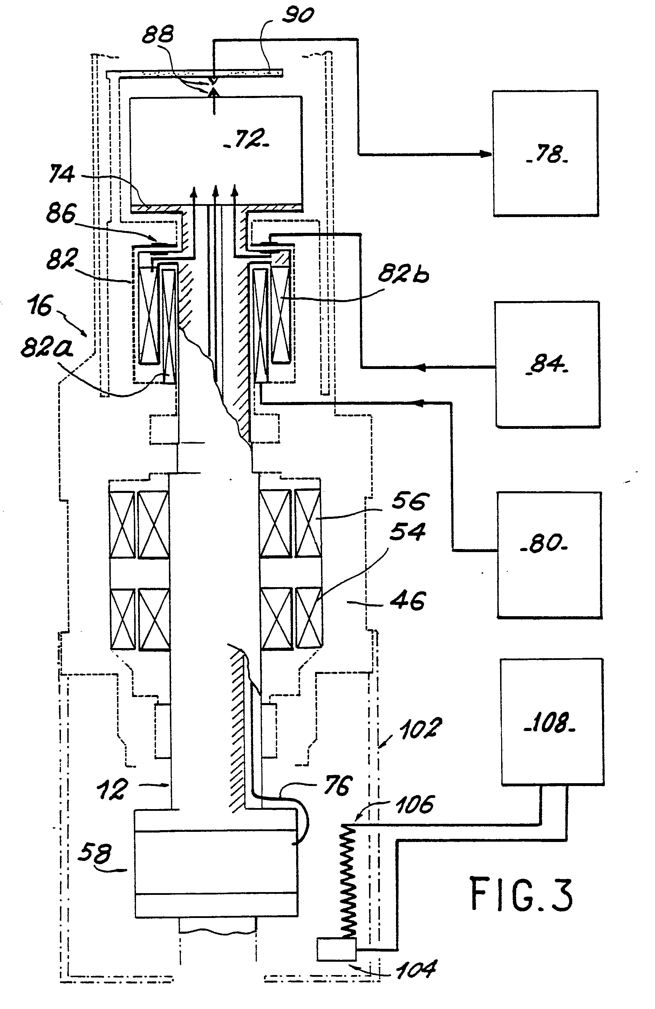

De plus, des moyens sont prévus pour réguler la température à l'intérieur de l'enceinte 102. Ces moyens comprennent une sonde de température 104 et un organe de chauffage 106 fixés à l'intérieur de l'enceinte 102, ainsi qu'un circuit de régulation électronique 108 logé dans la console de commande (non représentée). La sonde 104 et l'organe de chauffage 106 sont reliés électriquement au circuit 108 comme l'illustre schématiquement la figure 3, de telle sorte que l'organe de chauffage, commandé par le circuit 108, permette de stabiliser la température en fonction des informations délivrées par la sonde de température. La température sur le capteur de poids peut ainsi être stabilisée par exemple au voisinage de 35 °C environ. En outre, afin d'éliminer les ponts thermiques qui existent entre le milieu extérieur et le capteur de poids 58, les parties 12'a et 12'c de la broche de tirage adjacentes au capteur sont réalisées en un matériau isolant tel que l'alumine.

Afin de résoudre le problème de la transmission des signaux électriques délivrés par le capteur de poids 58 jusqu'aux parties non tournantes de la machine, on voit en se référant à la figure 3 qu'on a fait appel à différentes techniques de transmission selon la nature des signaux, ces techniques ayant en commun de supprimer tout contact électrique tournant entre la broche et la partie 46 du chariot 16.

En premier lieu, et afin de réduire autant que possible la longueur des fils électriques avant que les signaux délivrés par le capteur 58 ne subissent un premier traitement, ce qui permet d'éviter la création de parasites qui pourraient être préjudiciables à la mesure, un premier circuit électronique ou circuit de traitement préliminaire 72 est embarqué directement sur un plateau 74 monté à l'extrémité supérieure de la broche de tirage 12, au-dessus de la partie 46 du chariot. Les fils 76 permettant d'acheminer jusqu'au circuit 72 les signaux électriques délivrés par le capteur 58 traversent des passages appropriés formés dans la partie supérieure 12a de la broche de tirage, comme on l'a représenté sur les figures 2 et 3.

Le circuit de traitement 72 a principalement pour fonctions d'amplifier le signal en provenance du capteur de poids, de multiplexer ce signal amplifié ainsi que des grandeurs analogiques annexes telles que des mesures de températures, puis de convertir toutes ces grandeurs en un train d'impulsions dans un convertisseur tension-fréquence, par exemple à 1 MhZ.

Compte tenu des différentes fonctions du circuit de traitement 72, on voit que trois types de grandeurs devront circuler entre le circuit 72 et différents éléments appartenant à la console de commande (non représentée) :
— la tension d'alimentation du circuit 72, délivrée par une source de tension 80,
— les ordres de multiplexage des grandeurs conditionnées dans le circuit 72 ainsi que certains ordres de contrôle annexes délivrés par un calculateur 84 ; et
— les informations délivrées par le circuit 72 et qui doivent être transférées jusqu'au circuit de traitement principal 78 logé dans la console.

En premier lieu et comme l'illustre la figure 3, la tension d'alimentation du circuit 72 délivrée par la source 80 est transmise de la partie 46 du chariot 16 au circuit 72 tournant avec la broche 12 par un transformateur tournant 82 dont le primaire 82a est solidaire de la partie 46 et disposé à l'intérieur du secondaire 82b, solidaire de la broche 12.

D'autre part, les ordres délivrés par le calculateur 84 sont transmis au circuit 72 entre la partie 46 et la broche 12, par l'intermédiaire d'un système de couplage capacitif 86, par exemple sur une porteuse à 3 MhZ.

Enfin, les informations fournies sous la forme d'un train d'impulsions par le circuit de traitement 72 sont transmises au circuit de traitement principal 78 par un système émetteur-récepteur électro-optique constitué par une photodiode et un photo-transistor 88 placés selon l'axe de la broche 12, disposées en vis-à-vis, et solidaires respectivement du circuit embarqué 72 et d'une plaque 90 fixée à la partie 46 du chariot.

Afin de permettre l'interchangeabilité de la partie de la broche 12 portant le germe, on voit sur la figure 2 que la partie inférieure 12b de la broche est montée par un dispositif démontable 92 sur une partie intermédiaire 12c, elle-même reliée à la partie supérieure 12a par l'intermédiaire du capteur de poids 58.

De façon plus précise, le dispositif démontable 92 est constitué par une goupille 94 qui pénètre simultanément dans des trous 96 et 98, par exemple de forme carrée, formés respectivement dans les extrémités complémentaires des parties 12b et 12c de la broche de tirage. Le maintien en position de la goupille dans les trous est obtenu par un ressort 100. Ce dispositif présente l'avantage de permettre un démontage très facile de la partie inférieure 12b en exerçant une légère pression vers le haut à l'encontre du ressort 100, de façon à dégager la goupille 94 des trous 96 et 98. De plus, ce dispositif assure un centrage parfait sans jeu longitudinal ni rotatif.

## Revendications

1. Machine de tirage de monocristaux à partir d'un bain de produit fondu (15) contenu dans un creuset (14) et maintenu à une température supérieure au point de fusion du produit par des moyens de chauffage appropriés, à l'aide d'un germe monocristallin dudit produit placé à l'extrémité inférieure d'une broche de tirage (12) d'axe vertical ladite machine comprenant un bâti fixe (10) ; un chariot (16) supporté par le bâti et mobile par rapport audit bâti selon une direction parallèle à l'axe de la broche de tirage (12), et des moyens (32, 40) pour guider le chariot par rapport au bâti, des premiers moyens (18) de commande montés sur le bâti pour déplacer ledit chariot dans ladite direction selon au moins deux vitesses différentes en agissant sur une vis (24) reçue dans un écrou (27) monté sur le chariot, le chariot (16) supportant la broche de tirage de façon tournante autour de l'axe de cette dernière, et des seconds moyens (54) de commande montés sur le chariot pour faire tourner la broche de tirage autour de son axe vertical, cette machine étant caractérisée en ce que :

— les premiers moyens de commande comprennent un seul moteur couple (18) asservi en position et en vitesse, ce moteur étant en prise directe sur la vis (24) ;

— les seconds moyens de commande comprennent un second moteur couple (54) asservi en vitesse, ce moteur étant en prise directe sur la broche de tirage (12) ;

— la broche de tirage est formée de deux parties (12a, 12b) séparées reliées fixement par un capteur de poids (58) tournant avec les deux parties de la broche et délivrant des signaux électriques transmis à un premier circuit de traitement électronique (72) solidaire de la broche de tirage (12) ;

— le premier circuit de traitement électronique (72) délivre des signaux électriques qui sont transmis à un deuxième circuit de traitement électronique (78), indépendant de la broche de tirage, par un système électro-optique (88) disposé selon l'axe de la broche entre le premier circuit de traitement électronique et le chariot ;

— la machine comprenant de plus une source d'alimentation électrique (80) du premier circuit de traitement électronique (72) indépendante de la broche de tirage, et un transformateur (82) disposé entre le chariot et la broche de tirage et par lequel ladite source est reliée électriquement et sans contact au premier circuit de traitement électronique ;

— des moyens (84) pour délivrer des ordres de commande au premier circuit de traitement électronique, ces moyens étant indépendants de la broche de tirage, et des moyens de couplage capacitifs (86) disposés entre le chariot et la broche de tirage et par lesquels les moyens pour délivrer des ordres de commande sont reliés électriquement et sans contact au premier circuit de traitement électronique.

2. Machine de tirage selon la revendication 1, caractérisée en ce que le capteur de poids (58) est logé dans une enceinte (102) thermiquement isolante solidaire dudit chariot (16).

3. Machine de tirage selon la revendication 2, caractérisée en ce qu'elle comprend de plus une sonde de température (104) et un moyen de chauffage (106) placés dans ladite enceinte (102), un circuit de régulation externe (108) sensible aux signaux délivrés par la sonde de température commandant la mise en œuvre du moyen de chauffage afin de maintenir la température sur le capteur de poids à une valeur constante.

4. Machine de tirage selon l'une quelconque des revendications 1 à 3, caractérisée en ce que chacune desdites parties (12a, 12b) de la broche comporte au moins une zone en matériau isolant au voisinage du capteur de poids.

5. Machine de tirage selon l'une quelconque des revendications 1 à 4, caractérisée en ce que ledit système électro-optique comprend un émetteur et un récepteur opto-électroniques (88) disposés en vis-à-vis selon l'axe de la broche (12) et solidaires respectivement du premier circuit de traitement électronique (72) et du chariot (16).

6. Machine de tirage selon l'une quelconque des revendications 1 à 5, caractérisée en ce que le capteur de poids (58) comprend une pièce externe (60) solidaire d'une première partie (12b, 12c) de la broche de tirage et centrée selon l'axe de celle-ci par des premiers moyens de centrage (70), une pièce interne (62) solidaire d'une deuxième partie (12a) de la broche de tirage et centrée selon l'axe de celle-ci par des deuxièmes moyens de centrage (64), et des moyens pour mesurer le déplacement relatif entre ces deux pièces selon l'axe de la broche.

7. Machine de tirage selon la revendication 6, caractérisée en ce que la pièce externe (60) du capteur de poids est centrée sur ladite première partie (12b, 12c) selon l'axe de la broche de tirage par un embrèvement (70), la pièce interne (62) comportant une partie en saillie par rapport à la pièce externe, logée dans un trou borgne (64) formé dans la deuxième partie (12a) de la broche de tirage, afin de centrer la pièce interne selon l'axe de cette dernière.

8. Machine de tirage selon l'une quelconque des revendications précédentes, caractérisée en ce que la broche de tirage comporte une extrémité inférieure démontable (12b).

9. Machine de tirage selon l'une quelconque des revendications précédentes, caractérisée en ce que le chariot (16) comprend une première partie (44) portant lesdits moyens de guidage (32, 40) et ledit écrou (27) une deuxième partie (46) portant la broche de tirage (12) et les moyens (54) pour en commander la rotation, l'ensemble constitué par la deuxième partie (46) du chariot et par la broche de tirage (12) présentant pour l'essentiel une symétrie de révolution autour de l'axe de ladite broche (12), et des moyens de liaison (48) rigides et réglables entre ces deux parties du chariot, permettant de conférer à l'axe de la broche l'orientation verticale souhaitée.

10. Machine de tirage selon l'une quelconque des revendications précédentes, caractérisée en ce que les moyens pour guider le chariot par rapport au bâti comprennent au moins un rail de guidage (32) solidaire du bâti (10) et au moins deux paires de galets (40) verticalement espacées, portées par le chariot (16) et roulant sur ledit rail.

## Claims

1. Machine for pulling monocrystals from a molten product bath (15) contained in a crucible (14) and maintained at a temperature above the melting point of the product by appropriate heating means, using a monocrystalline nucleus of said product placed at the lower end of a vertically axed pulling spindle (12), said machine comprising a fixed frame (10) ; a carriage (16) supported by the frame and mobile with respect to the latter in a direction parallel to the axis of the pulling spindle (12) and means (32, 40) for guiding the carriage with respect to the frame, first control means (18) mounted on the frame in order to move the latter in said direction at least two different speeds whilst acting on a screw (24) received in a nut (27) mounted on the carriage, carriage (16) supporting the pulling spindle in such a way as to rotate about the axis of the latter, and second control means (54) mounted on the carriage for rotating the pulling spindle about its vertical axis, said machine being characterized in that :

the first control means comprise a single torque motor (18) controlled in position and speed, said motor engaging directly on screw (24) ;

the second control means comprise a second speed-controlled torque motor (54), said motor engaging directly on the pulling spindle (12) ;

the pulling spindle is formed from two separate parts (12a, 12b) fixedly connected by a weight sensor (58) rotating with the two parts of the spindle and supplying electric signals transmitted to a first electronic processing circuit (72) integral with the pulling spindle (12) ;

the first electronic processing circuit (72) supplies electric signals which are transmitted to a second electronic processing circuit (78), independent of the pulling spindle, by an electrooptical system (88) disposed along the axis of the spindle between the first electronic processing circuit and the carriage ; the machine also comprising an electric power supply (80) for the first electronic processing circuit (72), independent of the pulling spindle, and a transformer (82) located between the carriage and the pulling spindle and by which said power supply is electrically connected and in contact-free manner to the first electronic processing circuit ;

means (84) for supplying control instructions to the first electronic processing circuit, said means being independent of the pulling spindle, and capacitive coupling means (86) located between the carriage and the pulling spindle and by which the means for supplying control instructions are electrically connected in contact-free manner to the first electronic processing circuit.

2. Pulling machine according to claim 1, characterized in that the weight sensor (58) is located in a thermally insulating enclosure (102) integral with carriage (16).

3. Pulling machine according to claim 2, characterized in that it also comprises a temperature detecting device (104) and heating means (106) placed in said enclosure (102), an outer regulating circuit (108) sensitive to the signals supplied by the temperature detecting device controlling the implementing of the heating means, in order to maintain the temperature on the weight sensor at a constant value.

4. Pulling machine according to any one of the claims 1 to 3, characterized in that each of said spindle parts (12a, 12b) has at least one insulating material zone in the vicinity of the weight sensor.

5. Pulling machine according to any one of the claims 1 to 4, characterized in that said electrooptical system comprises an optoelectronic transmitter and receiver (88) which face one another along the axis of spindle (12) and are respectively integral with the first electronic processing circuit (72) and the carriage (16).

6. Pulling machine according to any one of the claims 1 to 5, characterized in that the weight sensor (58) comprises an external member (60) integral with a first part (12b, 12c) of the pulling spindle and centred in accordance with the axis thereof by first centring means (70), an inner member (62) integral with the first part (12a) of the pulling spindle and centred along the axis thereof by second centring means (64) and means for measuring the relative displacement between said two members along the spindle axis.

7. Pulling machine according to claim 6, characterized in that the outer member (60) of the weight sensor is centred on said first part (12b, 12c) along the pulling spindle axis by a bevel shoulder (70), the inner member (62) having a part which projects with respect to the outer member located in a blind hole (64) formed in the second part (12a) of the pulling spindle, in order to centre the inner member along the axis of the latter.

8. Pulling machine according to any one of the preceding claims, characterized in that the pulling spindle has a dismantlable lower end (12b).

9. Pulling machine according to any one of the preceding claims, characterized in that the carriage (16) comprises a first part (44) carrying said guidance means (32, 40) and said nut (27), a second part (46) carrying the pulling spindle (12) and means (54) for controlling the rotation thereof, the assembly constituted by the second part (46) of the carriage and by the pulling spindle (12), essentially having a symmetry of revolution about the axis of said spindle (12), and rigid and regulatable connecting means (48) between said two parts of the carriage making it possible to give the desired vertical orientation to the spindle axis.

10. Pulling machine according to any one of the preceding claims, characterized in that the means for guiding the carriage relative to the frame comprise at least one guide rail (32) integral with frame (10) and at least two pairs of vertically spaced rollers (40) carried by carriage (16) and rolling on said rail.

## Patentansprüche

1. Vorrichtung zum Ziehen von Einkristallen aus dem Schmelzbad (15) eines Produkts, welches in einem Schmelztiegel (14) enthalten und durch geeignete Heizmittel auf einer Temperatur über dem Schmelzpunkt des Produkts gehalten ist, mit Hilfe eines einkristallischen Keims des Produkts, der am unteren Ende eines Ziehdorns (12) mit vertikaler Achse angeordnet ist, wobei die Vorrichtung umfaßt ein festes Gestell (10), einen von dem Gestell gehaltenen und in Bezug auf das Gestell längs einer zu der Achse des Ziehdorns (12) parallelen Richtung bewegbaren Wagen (16) und Einrichtungen (32, 40) zum Führen des Wagens in Bezug auf das Gestell, erste Steuereinrichtungen (18), die an dem Gestell angebracht sind, um den Wagen in der genannten Richtung mit wenigstens zwei unte schiedlichen Geschwindigkeiten unter Einwirken auf eine Schraube (24) zu verschieben, die von einer an dem Wagen gebrachten Mutter (27) aufgenommen ist, wobei der Wagen (16) den Ziehdorn um die Achse dieses letzteren drehbar hält, und zweite Steuereinrichtungen (54), die an dem Wagen angebracht sind, damit sich der Ziehdorn um seine vertikale Achse drehen kann, wobei diese Vorrichtung dadurch gekennzeichnet ist, daß

— die ersten Steuereinrichtungen einen einzigen positions- und geschwindigkeitsgeregelten Drehmotor (18) umfassen, wobei dieser Motor unmittelbar an der Schraube angreift, (18) umfassen, wobei dieser Motor die Schraube (24) unmittelbar angreift,

— die zweiten Steuereinrichtungen einen zweiten, geschwindigkeitsgeregelten Drehmomentmotor (54) umfassen, wobei dieser Motor direkt den Ziehdorn (12) antreibt,

— der Ziehdorn aus zwei getrennten Teilen (12a, 12b) gebildet ist, die fest über einen Gewichtsfühler (58) verbunden sind, der mit den zwei Teilen den Dorns dreht und elektrische Signale abgibt, die an einen ersten elektronischen, fest mit dem Ziehdorn (12) verbundenen, Verarbeitungsschaltkreis übertragen werden,

— der erste elektronische Verarbeitungsschaltkreis (72) elektrische Signale abgibt, die an einen zweiten, elektronischen Verarbeitungsschaltkreis (78), der von dem Ziehdorn unabhängig ist, über ein elektro-optisches System (88) übertragen werden, welches längs der Achse des Dorns zwischen dem ersten, elektronischen Verarbeitungsschaltkreis und dem Wagen angeordnet ist,

— die Vorrichtung ferner umfaßt eine von dem Ziehdorn unabhängige, elektronische Versorgungsquelle (80) für den ersten, elektronischen Verarbeitungsschaltkreis (72) und einen Transformator (82), der zwischen dem Wagen und dem Ziehdorn angeordnet ist und durch den die Quelle elektrisch und kontaktfrei mit dem ersten, elektronischen Verarbeitungsschaltkreis verbunden ist,

— Einrichtungen (84) zum Abgeben von Steuerbefehlen an den ersten, elektronischen Verarbeitungsschaltkreis, wobei diese Einrichtungen unabhängig von dem Ziehdorn sind, und kapazitive Kopplungseinrichtungen (86), die zwischen dem Wagen und dem Ziehdorn angeordnet sind und durch die die Einrichtungen zum Abgeben von Steuerbefehlen elektrisch und kontaktfrei mit dem ersten, elektronischen Verarbeitungsschaltkreis (72) verbunden sind.

2. Ziehvorrichtung nach Anspruch 1, dadurch gekennzeichnet, daß der Gewichtsfühler (58) in einer wärmeisolierten, mit dem Wagen (16) fest verbundenen Kammer (102) untergebracht ist.

3. Ziehvorrichtung nach Anspruch 2, dadurch gekennzeichnet, daß sie ferner einem Temperaturfühler (104) und eine Heizeinrichtung (106), die in der Kammer (102) angeordnet sind, und einen äußeren Regelschaltkreis (108) umfaßt, der auf die von dem Temperaturfühler abgegebenen Signale anspricht, und den Betrieb der Heizeinrichtung steuert, um die Temperatur an dem Gewichtsfühler auf einem konstanten Wert zu halten.

4. Ziehvorrichtung nach irgendeinem der Ansprüche 1 bis 3, dadurch gekennzeichnet, daß jeder der zwei Teile (12a, 12b) des Dorns in der Nähe des Gewichtsfühlers wenigstens einen Bereich aus Isoliermaterial aufweist.

5. Ziehvorrichtung nach irgendeinem der Ansprüche 1 bis 4, dadurch gekennzeichnet, daß das elektro-optische System einen opto-elektronischen Sender und Empfänger (88) aufweist, die einander gegenüberliegend längs der Achse des Dorns (12) angeordnet und mit dem ersten, elektronischen Verarbeitungsschaltkreis (72) bzw. dem Wagen (16) fest verbunden sind.

6. Ziehvorrichtung nach irgendeinem der Ansprüche 1 bis 5, dadurch gekennzeichnet, daß der Gewichtsfühler (58) ein äußeres Stück (60), welches fest mit einem ersten Teil (12b, 12c) des Ziehdorns verbunden und längs dessen Achse durch erste Zentrierungsmittel (70) zentriert ist, ein zweites Stück (62), welches fest mit einem zweiten Teil (12a) des Ziehdorns verbunden und längs dessen Achse durch zweite Zentrierungsmittel (64) zentriert ist, und Mittel umfaßt, um die relative Bewegung zwischen diesen zwei Stücken längs der Dornachse zu messen.

7. Ziehvorrichtung nach Anspruch 6, dadurch gekennzeichnet, daß das äußere Stück (60) des Gewichtsfühlers auf dem ersten Teil (12b, 12c) zu der Achse des Ziehdorns durch eine Versatzung (70) zentriert ist, das innere Stück (62) einen in Bezug aud das äußere Stück vorstehenden Teil aufweist, der in einem Sackloch (64) angeordnet ist, welches in dem zweiten Teil (12a) des Ziehdorns ausgebildet ist, um das innere Stück zu der Achse dieses letzteren zu zentrieren.

8. Ziehvorrichtung nach irgendeinem der vorhergehenden Ansprüche, dadurch gekennzeichnet, daß der Ziehdorn eine unteres, lösbares Ende (12b) aufweist.

9. Ziehvorrichtung nach irgendeinem der vorhergehenden Ansprüche, dadurch gekennzeichnet, daß der Wagen (16) ein erstes Teil (44), welches die Führungseinrichtungen (32, 40) und die Mutter (27) trägt, ein zweites Teil (46), welches den Ziehdorn (12) und die Einrichtungen (54) zur Steuerung der Drehung trägt, wobei die von den zwei Teilen (46) des Wagens und dem Ziehdorn (12) gebildete Gesamtheit im wesentlichen eine Drehsymmetrie um die Achse des genannten Dorns (12) aufweist, und steife und einstellbare Verbindungsmittel (48) zwischen diesen zwei Teilen des Wagens umfaßt, die ermöglichen, der Achse des Dorns die erwünschte, vertikale Ausrichtung zu verleihen.

10. Ziehvorrichtung nach irgendeinem der vorhergehenden Ansprüche, dadurch gekennzeichnet, daß die Einrichtungen zum Führen des Wagens in Bezug auf das Gestell wenigstens eine fest mit dem Gestell (10) verbundene Führungsschiene (32) und wenigstens zwei vertikal beabstandete Paare von Rollen (40) umfassen, die von dem Wagen (16) gehalten sind und auf der Schiene laufen.

0 143 676

FIG.1

0 143 676

FIG.2

FIG.3